# EUROPEAN PATENT APPLICATION

(11) **EP 4 629 799 A1**
(43) Date of publication of application: **08.10.2025**
(21) Application number: 25167246.5
(22) Date of filing: 31.03.2025
(51) Int. Cl.: H10K 59/122, H10K 71/20

(54) **DISPLAY DEVICE AND METHOD OF MANUFACTURING THE SAME**

(30) Priority: 02.04.2024 KR 20240044875
(71) Applicant: Samsung Display Co., Ltd., Yongin-si, Gyeonggi-do 17113 (KR)
(72) Inventor: Shin, Hyun Eok, 17113 Yongin-si, Gyeonggi-do (KR); Kim, A Rong, 17113 Yongin-si, Gyeonggi-do (KR); So, Byung Soo, 17113 Yongin-si, Gyeonggi-do (KR); Song, Seung Yong, 17113 Yongin-si, Gyeonggi-do (KR); Lee, Chang Hee, 17113 Yongin-si, Gyeonggi-do (KR); Im, Sung Soon, 17113 Yongin-si, Gyeonggi-do (KR); Jang, Keun Ho, 17113 Yongin-si, Gyeonggi-do (KR)
(74) Representative: Gulde & Partner

(57) **Abstract**

A display device includes a substrate, a pixel circuit layer disposed on the substrate, first, second, and third anodes disposed on the pixel circuit layer and spaced apart from each other, a pixel defining layer disposed on the pixel circuit layer and overlapping portions of the first, second, and third anodes, first, second, and third light emitting members respectively disposed on the first, second, and third anodes, and a common layer disposed on the first, second, and third light emitting members.

## Description

### BACKGROUND

### 1. Technical Field

Embodiments relate to a display device and a method of manufacturing the display device.

### 2. Description of the Related Art

As information technology develops, the importance of a display device, which is a connection medium between a user and information, has been highlighted. In response to this, a use of a display device such as a liquid crystal display device and an organic light emitting display device is increasing.

### SUMMARY

Embodiments provide a method of manufacturing a display device using a direct patterning process and a display device manufactured thereby.

However, embodiments are not limited to those set forth herein. The above and other embodiments will become more apparent to one of ordinary skill in the art to which the disclosure pertains by referencing the detailed description of the disclosure given below.

According to an embodiment, a display device may include a substrate, a pixel circuit layer disposed on the substrate, first, second, and third anodes disposed on the pixel circuit layer and spaced apart from each other, a pixel defining layer disposed on the pixel circuit layer and overlapping portions of the first, second, and third anodes, first, second, and third light emitting members respectively disposed on the first, second, and third anodes, and a common layer disposed on the first, second, and third light emitting members.

Each of the first, second, and third light emitting members may include a hole injection layer, a hole transport layer disposed on the hole injection layer, a light emitting layer disposed on the hole transport layer, and a first buffer layer disposed on the light emitting layer.

The common layer may include an electron transport layer, an electron injection layer disposed on the electron transport layer, and a cathode disposed on the electron injection layer.

The display device may further include a spacer disposed between the pixel defining layer and the electron transport layer and surrounding the first, second, and third light emitting members.

The common layer may further include a second buffer layer disposed on the spacer and the first, second, and third light emitting members and disposed under the electron transport layer.

The common layer may further include a second buffer layer disposed on the pixel defining layer and the first, second, and third light emitting members and disposed under the electron transport layer.

The display device may further include an encapsulation layer disposed on the common layer.

According to an embodiment, a method of manufacturing a display device may include forming a first anode, a second anode, a third anode, and a pixel defining layer on a pixel circuit layer on a substrate, forming a first light emitting member on the first anode, the second anode, the third anode, and the pixel defining layer, and forming a first sacrificial layer on the first light emitting member, forming a first photo resist on a portion overlapping a portion of the first anode of the first sacrificial layer, removing a portion that does not overlap the first photo resist of the first sacrificial layer, and removing a portion that does not overlap the first sacrificial layer of the first light emitting member and the first photo resist.

The method may further include forming a second light emitting member on the first sacrificial layer, the second anode, the third anode, and the pixel defining layer, and forming a second sacrificial layer on the second light emitting member, forming a second photo resist on a portion that overlaps a portion of the second anode of the second sacrificial layer, removing a portion that does not overlap the second photo resist of the second sacrificial layer, and removing a portion that does not overlap the second sacrificial layer of the second light emitting member and the second photo resist.

The method may further include forming a third light emitting member on the first sacrificial layer, the second sacrificial layer, the third anode, and the pixel defining layer, and forming a third sacrificial layer on the third light emitting member, forming a third photo resist on a portion overlapping a portion of the third anode of the third sacrificial layer, removing a portion that does not overlap the third photo resist of the third sacrificial layer, and removing a portion that does not overlap the third sacrificial layer of the third light emitting member and the third photo resist.

Each of the first, second, and third light emitting members may include a hole injection layer, a hole transport layer disposed on the hole injection layer, a light emitting layer disposed on the hole transport layer, and a first buffer layer disposed on the light emitting layer.

The method may further include forming a spacer on the pixel defining layer to cover the first, second, and third light emitting members and the first, second, and third sacrificial layers.

The method may further include removing a portion of the spacer to expose the first, second, and third sacrificial layers.

The method may further include removing the first, second, and third sacrificial layers.

The method may further include forming a common layer on the first, second, and third light emitting members and the spacer.

Forming the common layer may include forming an electron transport layer on the first, second, and third light emitting members and the spacer, forming an electron injection layer on the electron transport layer, and forming a cathode on the electron injection layer.

Forming the common layer may include forming a second buffer layer on the first, second, and third light emitting members and the spacer, forming an electron transport layer on the second buffer layer, forming an electron injection layer on the electron transport layer, and forming a cathode on the electron injection layer.

The method may further include removing the first, second, and third sacrificial layers.

The method may further include forming a common layer on the first, second, and third light emitting members and the pixel defining layer.

Forming the common layer may include forming a second buffer layer on the first, second, and third light emitting members and the pixel defining layer, forming an electron transport layer on the second buffer layer, forming an electron injection layer on the electron transport layer, and forming a cathode on the electron injection layer.

### BRIEF DESCRIPTION OF THE DRAWINGS

The above and other features of the disclosure will become more apparent by describing in further detail embodiments thereof with reference to the accompanying drawings, in which:
FIG. 1 is a schematic block diagram illustrating a display device according to an embodiment.
FIG. 2 is a schematic block diagram illustrating a sub-pixel according to an embodiment.
FIG. 3 is a schematic plan view illustrating a display panel according to an embodiment.
FIG. 4 is a schematic cross-sectional view illustrating a display panel according to an embodiment.
FIG. 5 is a schematic cross-sectional view illustrating a display panel according to an embodiment.
FIG. 6 is a schematic plan view illustrating a pixel according to an embodiment.
FIG. 7 is a schematic cross-sectional view taken along line I-I' of FIG. 6 according to an embodiment.
FIG. 8 is a schematic cross-sectional view taken along line I-I' of FIG. 6 according to an embodiment.
FIG. 9 is a schematic cross-sectional view taken along line I-I' of FIG. 6 according to an embodiment.
FIG. 10 is a schematic block diagram illustrating a method of manufacturing a display device according to an embodiment.
FIGS. 11 to 29 are schematic cross-sectional views schematically illustrating a method of manufacturing a display device according to an embodiment.
FIG. 30 is a schematic block diagram illustrating a display system according to an embodiment.
FIGS. 31 to 34 are schematic perspective views illustrating application examples of the display system of FIG. 30.

### DETAILED DESCRIPTION OF THE EMBODIMENTS

Hereinafter, a preferred embodiment according to the disclosure is described in detail with reference to the accompanying drawings. It should be noted that in the following description, only portions necessary for understanding an operation according to the disclosure are described, and descriptions of other portions are omitted in order not to obscure the subject matter of the disclosure. In addition, the disclosure may be embodied in other forms without being limited to the embodiment described herein. However, the embodiment described herein is provided to describe in detail enough to easily implement the technical spirit of the disclosure to those skilled in the art to which the disclosure belongs.

Throughout the specification, in a case where a portion is "connected" to another portion, the case includes not only a case where the portion is "directly connected" but also a case where the portion is "indirectly connected" with another element interposed therebetween. Terms used herein are for describing specific embodiments and are not intended to limit the disclosure. Throughout the specification, in a case where a certain portion "includes", the case means that the portion may further include another component without excluding another component unless otherwise stated. "At least any one of X, Y, and Z" and "at least any one selected from a group consisting of X, Y, and Z" may be interpreted as one X, one Y, one Z, or any combination of two or more of X, Y, and Z (for example, XYZ, XYY, YZ, and ZZ). Here, "and/or" includes all combinations of one or more of corresponding configurations.

Here, terms such as first and second may be used to describe various components, but these components are not limited to these terms. These terms are used to distinguish one component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment, the term "under" may include both directions of on and under. In addition, the device may face in other directions (for example, rotated 90 degrees or in other directions) and thus the spatially relative terms used herein are interpreted according thereto.

Various embodiments are described with reference to drawings schematically illustrating ideal embodiments. Accordingly, it will be expected that shapes may vary, for example, according to tolerances and/or manufacturing techniques. Therefore, the embodiments disclosed herein cannot be construed as being limited to shown specific shapes, and should be interpreted as including, for example, changes in shapes that occur as a result of manufacturing. As described above, the shapes shown in the drawings may not show actual shapes of areas of a device, and the present embodiments are not limited thereto.

Hereinafter, embodiments are described in detail with reference to the accompanying drawings.

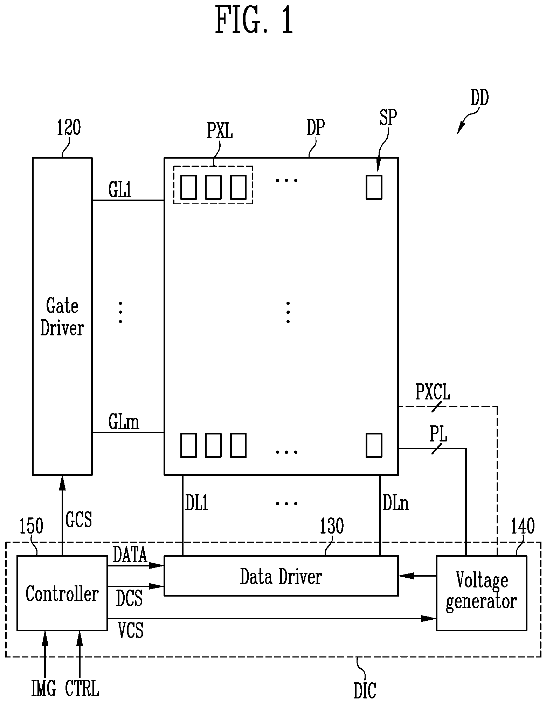

FIG. 1 is a schematic block diagram illustrating a display device according to an embodiment.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light of two or more colors. For example, each of the sub-pixels SP may generate light such as red, green, blue, cyan, magenta, or yellow.

Two or more sub-pixels among the sub-pixels SP may form a pixel (e.g., single pixel) PXL. For example, the pixel PXL may include three sub-pixels as shown in FIG. 1. As described above, the pixel PXL may emit light of various colors and various luminances according to a combination of light emitted from the sub-pixels included in the pixel PXL.

The gate driver 120 may be connected to the sub-pixels SP arranged in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, and the like.

The gate driver 120 may be disposed on one side of the display panel DP. However, embodiments are not limited thereto. For example, the gate driver 120 may be divided into two or more physically and/or logically divided drivers, and the drivers may be disposed on one side of the display panel DP and another side of the display panel DP opposite the one side. As described above, the gate driver 120 may be disposed around the display panel DP in various shapes according to embodiments.

The data driver 130 may be connected to the sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock, a source output enable signal, and the like.

The data driver 130 may receive voltages from the voltage generator 140. The data driver 130 may apply data signals having grayscale voltages corresponding to the image data DATA to the first to n-th data lines DL1 to DLn using the received voltages. In case that the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may generate voltages and provide the generated voltages to components of the display device DD, such as the gate driver 120, the data driver 130, and the controller 150. The voltage generator 140 may generate the voltages by receiving an input voltage from an outside of the display device DD and regulating the received voltage.

The voltage generator 140 may generate a first power voltage and a second power voltage. The generated first and second power voltages may be provided to the sub-pixels SP through power lines PL. In another embodiment, at least one of the first and second power voltages may be provided from the outside of the display device DD.

For example, the voltage generator 140 may provide various voltages and/or signals. For example, the voltage generator 140 may provide one or more initialization voltages applied to the sub-pixels SP. For example, during a sensing operation for sensing electrical characteristics of transistors and/or light emitting elements of the sub-pixels SP, a selected reference voltage may be applied to the first to n-th data lines DL1 to DLn, and the voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, the pixel control lines PXCL may be connected between the voltage generator 140 and the display panel DP, but embodiments are not limited thereto. For example, the pixel control lines PXCL may be connected between the gate driver 120 and the display panel DP. For example, the pixel control signals may be transmitted from the voltage generator 140 to the pixel control lines PXCL through the gate driver 120.

The controller 150 may control overall operations of the display device DD. The controller 150 may receive input image data IMG and a control signal CTRL corresponding thereto from the outside. The controller 150 may provide the gate control signal GCS, the data control signal DCS, and the voltage control signal VCS in response to the control signal CTRL.

The controller 150 may convert the input image data IMG so that the input image data IMG may be suitable for the display device DD or the display panel DP and output the image data DATA. In embodiments, the controller 150 may output the image data DATA by aligning the input image data IMG so that the input image data IMG may be suitable for the sub-pixels SP of a row unit.

Two or more components of the data driver 130, the voltage generator 140, and the controller 150 may be mounted on one integrated circuit. As shown in FIG. 1, the data driver 130, the voltage generator 140, and the controller 150 may be included in a driver integrated circuit DIC. For example, the data driver 130, the voltage generator 140, and the controller 150 may be functionally divided components in a driver integrated circuit (e.g., single driver integrated circuit) DIC. In other embodiments, at least one of the data driver 130, the voltage generator 140, and the controller 150 may be provided as a component distinguished from the driver integrated circuit DIC.

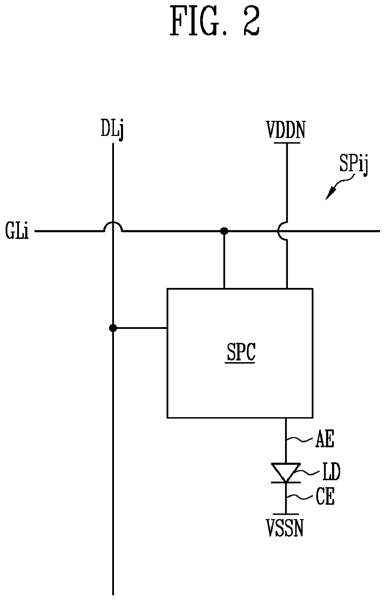

FIG. 2 is a schematic block diagram illustrating a sub-pixel according to an embodiment. In FIG. 2, among the sub-pixels SP of FIG. 1, a sub-pixel SPij arranged in an i-th row (i is an integer greater than or equal to 1 and less than or equal to m) and a j-th column (j is an integer greater than or equal to 1 and less than or equal to n) is shown as an example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL of FIG. 1 and receive the first power voltage. The second power voltage node VSSN may be connected to another one of the power lines PL of FIG. 1 and may receive the second power voltage. The first power voltage may have a voltage level higher than that of the second power voltage.

The light emitting element LD may be connected between an anode AE and a cathode CE. The anode AE may be connected to the first power voltage node VDDN through the sub-pixel circuit SPC. For example, the anode AE may be connected to the first power voltage node VDDN through one or more transistors included in the sub-pixel circuit SPC. The cathode CE may be connected to the second power voltage node VSSN. The light emitting element LD may emit light according to a current flowing from the anode AE to the cathode CE.

The sub-pixel circuit SPC may be connected to an i-th gate line GLi among the first to m-th gate lines GL1 to GLm of FIG. 1, and a j-th data line DLj among the first to n-th data lines DL1 to DLn of FIG. 1. In response to a gate signal received through the i-th gate line GLi, the sub-pixel circuit SPC may control the light emitting element LD to emit light according to a data signal received through the j-th data line DLj. In embodiments, the sub-pixel circuit SPC may be further connected to the pixel control lines PXCL of FIG. 1. For example, the sub-pixel circuit SPC may control the light emitting element LD in further response to the pixel control signals received through the pixel control lines PXCL.

For such operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal oxide silicon field effect transistor (MOSFET). In embodiments, the transistors of the sub-pixel circuit SPC may include an amorphous silicon semiconductor, a monocrystalline silicon, a polycrystalline silicon semiconductor, an oxide semiconductor, and the like.

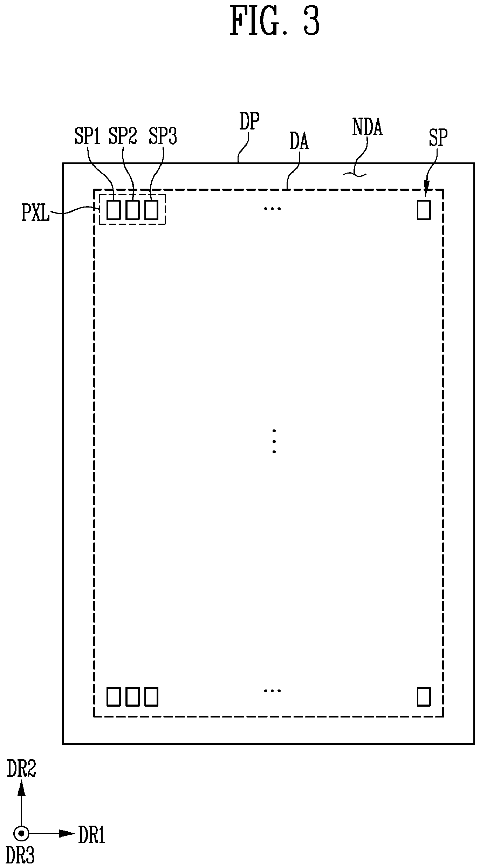

FIG. 3 is a schematic plan view illustrating a display panel according to an embodiment.

Referring to FIG. 3, the display panel DP may include a display area DA and a non-display area NDA. The display panel DP may display an image through the display area DA. The non-display area NDA may be disposed around the display area DA.

The display panel DP may include the sub-pixels SP in the display area DA. The sub-pixels SP may be arranged along a first direction DR1 and a second direction DR2 intersecting the first direction DR1. For example, the sub-pixels SP may be arranged in a matrix form along the first direction DR1 and the second direction DR2. As another example, the sub-pixels SP may be arranged in a zigzag form along the first direction DR1 and the second direction DR2. An arrangement of the sub-pixels SP may vary according to embodiments. The first direction DR1 may be a column direction, and the second direction DR2 may be a row direction.

Two or more sub-pixels among the sub-pixels SP may configure one pixel PXL. In FIG. 3, the pixel PXL may include three sub-pixels SP1 to SP3, but embodiments are not limited thereto. For example, the pixel PXL may include two sub-pixels. Hereinafter, for convenience of description, it is assumed that the pixel PXL may include the first to third sub-pixels SP1 to SP3.

Each of the first to third sub-pixels SP1 to SP3 may generate light of one of various colors such as red, green, blue, cyan, magenta, and yellow. Hereinafter, for clear and concise description, it is assumed that the first sub-pixel SP1 may generate light of a red color, the second sub-pixel SP2 may generate light of a green color, and the third sub-pixel SP3 may generate light of a blue color.

Each of the first to third sub-pixels SP1 to SP3 may include at least one light emitting element that generates light. In embodiments, the light emitting elements of the first to third sub-pixels SP1 to SP3 may generate light of the same color. For example, the light emitting elements of the first to third sub-pixels SP1 to SP3 may generate the light of the blue color. In other embodiments, the light emitting elements of the first to third sub-pixels SP1 to SP3 may generate light of different colors. For example, the light emitting elements of the first to third sub-pixels SP1 to SP3 may generate light of a red color, a green color, and a blue color, respectively.

As the display panel DP, a light emitting diode display panel (LED display panel) using a micro scale or nano scale of light emitting diode as a light emitting element, and a display panel capable of self-emission such as an organic light emitting display panel (OLED panel) using an organic light emitting diode as a light emitting element may be used.

A component for controlling the sub-pixels SP may be disposed in the non-display area NDA. Lines connected to the sub-pixels SP, for example, the first to m-th gate lines GL1 to GLm of FIG. 1, the first to n-th data lines DL1 to DLn, the power lines PL, and the pixel control lines PXCL may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. For example, the data driver 130, the voltage generator 140, and the controller 150 may be implemented as a driver integrated circuit DIC of FIG. 1, separate from the display panel DP, and the driver integrated circuit DIC may be connected to the lines disposed in the non-display area NDA. In other embodiments, the gate driver 120 may be implemented as one integrated circuit separate from the display panel DP, together with the data driver 130, the voltage generator 140, and the controller 150. In this way, advantageously, the energy consumption, the manufacturing costs and the installation space requirements can be effectively minimized.

In embodiments, the display area DA may have various shapes. The display area DA may have a closed loop shape including sides of a straight line and/or a curved line. For example, the display area DA may have shapes of a polygon, a circle, a semicircle, an ellipse, and the like.

In embodiments, the display panel DP may have a flat display surface. In other embodiments, the display panel DP may have a display surface that is at least partially round. In embodiments, the display panel DP may be bendable, foldable, or rollable. In such cases, the display panel DP and/or a substrate of the display panel DP may include materials having a flexible property.

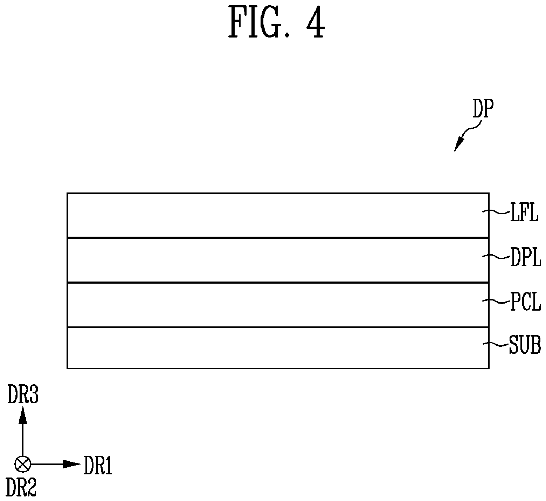

FIG. 4 is a schematic cross-sectional view illustrating a display panel according to an embodiment.

Referring to FIG. 4, the display panel DP may include a substrate SUB, and a pixel circuit layer PCL, a display element layer DPL, and a light functional layer LFL sequentially stacked on the substrate SUB in a third direction DR3 intersecting the first and second directions DR1 and DR2.

The substrate SUB may be formed of an insulating material such as glass or resin. For example, the substrate SUB may include a glass substrate. As another example, the substrate SUB may include a polyimide (PI) substrate. As still another example, the substrate SUB may include a silicon wafer substrate formed using a semiconductor process.

In embodiments, the substrate SUB may be formed of a flexible material that is bent or folded, and may have a single-layer structure or a multi-layer structure. For example, the flexible material may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers and semiconductor patterns and conductive patterns disposed between the insulating layers. The conductive patterns of the pixel circuit layer PCL may function as circuit elements, lines, and the like.

The circuit elements of the pixel circuit layer PCL may include the sub-pixel circuit SPC (refer to 2) of each of the sub-pixels SP of FIG. 3. For example, the circuit elements of the pixel circuit layer PCL may be provided as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines necessary to drive the display element layer DPL.

The display element layer DPL may be disposed on the pixel circuit layer PCL. The display element layer DPL may include light emitting elements of the sub-pixels SP.

The light functional layer LFL may be disposed on the display element layer DPL. The light functional layer LFL may include light conversion patterns having color conversion particles and/or scattering particles. For example, the color conversion particles may include quantum dots. The quantum dots may change a wavelength (or color) of light emitted from the display element layer DPL. The light functional layer LFL may further include light scattering patterns having the scattering particles. In embodiments, the light conversion patterns and the light scattering patterns may be omitted.

The light functional layer LFL may further include a color filter layer including color filters. The color filter may selectively transmit light of a specific wavelength (or a specific color). In embodiments, the color filter layer may be omitted.

A window for protecting an exposure surface (or an upper surface) of the display panel DP may be provided on the light functional layer LFL. The window may protect the display panel DP from external shock. The window may be coupled to the light functional layer LFL through an optically transparent adhesive (or cohesive) member. The window may have a multi-layer structure selected from a glass substrate, a plastic film, and a plastic substrate. The multi-layer structure may be formed through a continuous process or an adhesion process using an adhesive layer. All or a portion of the window may be flexible.

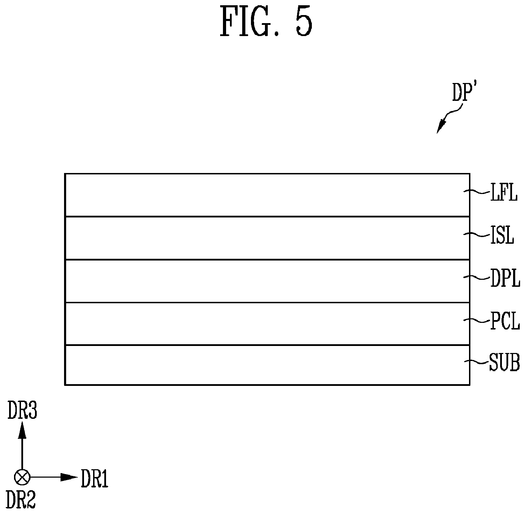

FIG. 5 is a schematic cross-sectional view illustrating a display panel according to an embodiment.

Referring to FIG. 5, the display panel DP' may include the substrate SUB, the pixel circuit layer PCL, the display element layer DPL, an input sensing layer ISL, and the light functional layer LFL. The substrate SUB, the pixel circuit layer PCL, the display element layer DPL, and the light functional layer LFL may be implemented similarly to the substrate SUB, the pixel circuit layer PCL, the display element layer DPL, and the light functional layer LFL described with reference to FIG. 4, respectively. Hereinafter, an overlapping description is omitted for descriptive convenience.

The input sensing layer ISL may sense a user input on an upper surface (or a display surface) of the display panel DP'. The input sensing layer ISL may include components suitable for sensing an external object such as a user's hand, or a pen. For example, the input sensing layer ISL may include touch electrodes.

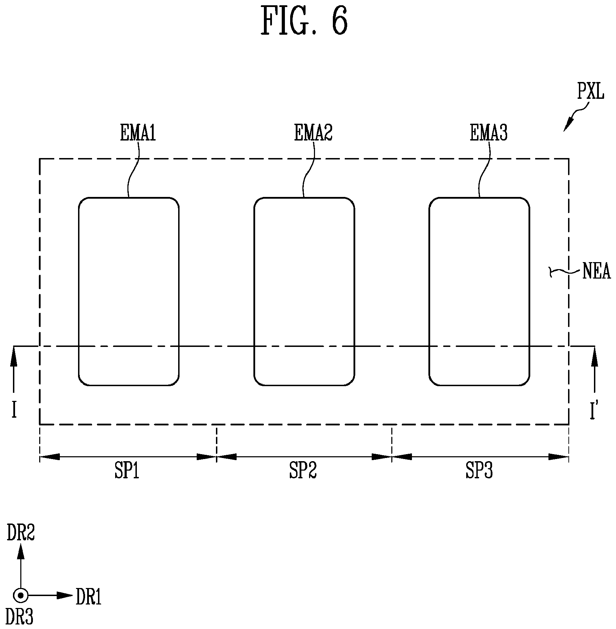

FIG. 6 is a schematic plan view illustrating a pixel according to an embodiment.

Referring to FIG. 6, the pixel PXL may include the first to third sub-pixels SP1 to SP3 arranged in the first direction DR1.

The first sub-pixel SP1 may include a first emission area EMA1 and a non-emission area NEA around the first emission area EMA1. The second sub-pixel SP2 may include a second emission area EMA2 and a non-emission area NEA around the second emission area EMA2. The third sub-pixel SP3 may include a third emission area EMA3 and a non-emission area NEA around the third emission area EMA3.

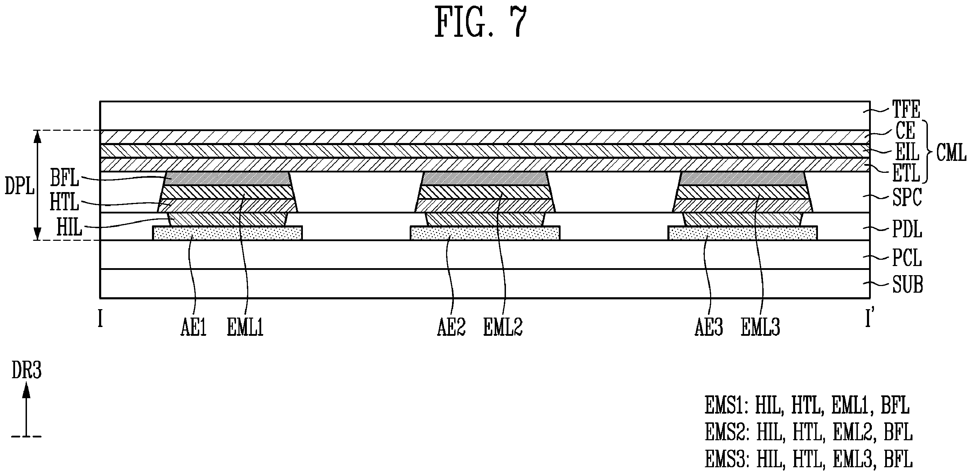

The first emission area EMA1 may be an area where light is emitted from a portion of a first light emitting structure (or first light emitting member) EMS1 (refer to FIG. 7) corresponding to the first sub-pixel SP1. The second emission area EMA2 may be an area where light is emitted from a portion of a second light emitting structure (or second light emitting member) EMS2 (refer to FIG. 7) corresponding to the second sub-pixel SP2. The third emission area EMA3 may be an area where light is emitted from a portion of a third light emitting structure (or third light emitting member) EMS3 (refer to FIG. 7) corresponding to the third sub-pixel SP3.

FIG. 7 is a schematic cross-sectional view taken along line I-I' of FIG. 6 according to an embodiment.

Referring to FIG. 7, the pixel circuit layer PCL may be disposed on the substrate SUB. The pixel circuit layer PCL may include insulating layers, semiconductor patterns, and conductive patterns stacked on the substrate SUB. The insulating layers may include a buffer layer, one or more interlayer insulating layers, and one or more passivation layers. The semiconductor patterns and the conductive patterns may be positioned between the insulating layers. The conductive patterns may function as at least a portion of circuit elements, lines, and the like. The conductive patterns may include at least one of copper (Cu), molybdenum (Mo), tungsten (W), aluminum neodymium (AlNd), titanium (Ti), aluminum (Al), and silver (Ag), but embodiments are not limited thereto.

The circuit elements may include the sub-pixel circuit SPC (refer to FIG. 2) for each of the first to third sub-pixels SP1 to SP3 (refer to FIG. 6). The sub-pixel circuit SPC may include transistors and one or more capacitors. Each transistor may include a semiconductor portion including a source area, a drain area, and a channel area, and a gate electrode overlapping the semiconductor portion. In embodiments, in case that the substrate SUB is provided as a silicon substrate, the semiconductor portion may be included in the substrate SUB, and the gate electrode may be included in the pixel circuit layer PCL as a conductive pattern of the pixel circuit layer PCL. In embodiments, in case that the substrate SUB is provided as a glass substrate or a PI substrate, the semiconductor portion and the gate electrode may be included in the pixel circuit layer PCL. Each capacitor may include electrodes spaced apart from each other. For example, each capacitor may include electrodes spaced apart from each other in the third direction DR3 with an insulating layer therebetween.

The lines of the pixel circuit layer PCL may include signal lines connected to each of the first to third sub-pixels SP1 to SP3, for example, a gate line, an emission control line, a data line, and the like. The lines may further include a line connected to the first power voltage node VDDN of FIG. 2. For example, the lines may further include a line connected to the second power voltage node VSSN of FIG. 2.

In embodiments, a via layer may be disposed on the pixel circuit layer PCL. The via layer may cover the pixel circuit layer PCL, and may have a generally flat surface. The via layer may include at least one of silicon oxide (SiOₓ), silicon nitride (SiNₓ), and silicon carbon nitride (SiCN), but embodiments are not limited thereto.

The display element layer DPL may be disposed on the pixel circuit layer PCL. The display element layer DPL may include first to third anodes AE1 to AE3, a pixel defining layer PDL, the first to third light emitting structures EMS1 to EMS3, a spacer SPC, and a common layer CML.

The first to third anodes AE1 to AE3 may be disposed on the pixel circuit layer PCL. The first to third anodes AE1 to AE3 may be spaced apart from each other. For example, the first to third anodes AE1 to AE3 may be respectively disposed in the first to third sub-pixels SP1 to SP3 (refer to FIG. 6). The first anode AE1 may be provided as the anode AE (refer to FIG. 2) included in the sub-pixel circuit SPC (refer to FIG. 2) of the first sub-pixel SP1. The second anode AE2 may be provided as the anode AE included in the sub-pixel circuit SPC of the second sub-pixel SP2. The third anode AE3 may be provided as the anode AE included in the sub-pixel circuit SPC of the third sub-pixel SP3.

The first to third anodes AE1 to AE3 may include at least one of transparent conductive materials such as indium tin oxide (ITO), indium zinc oxide (IZO), zinc oxide (ZnO), indium gallium zinc oxide (IGZO), and indium tin zinc oxide (ITZO). However, embodiments are not limited thereto. For example, the first to third anodes AE1 to AE3 may include titanium nitride (TiN).

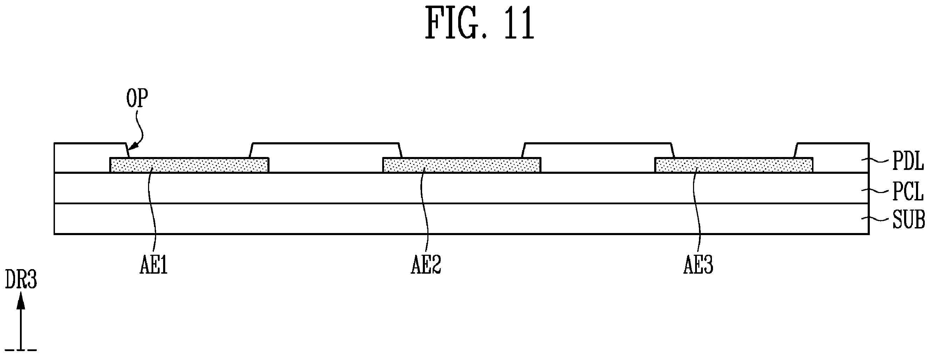

The pixel defining layer PDL may be disposed on the pixel circuit layer PCL. The pixel defining layer PDL may overlap portions of the first to third anodes AE1 to AE3. For example, the pixel defining layer PDL may be disposed (e.g., directly disposed) on the portions of the first to third anodes AE1 to AE3. The pixel defining layer PDL may include an opening OP (refer to FIG. 11) exposing a portion of each of the first to third anodes AE1 to AE3. The opening OP of the pixel defining layer PDL may define an emission area of each of the first to third sub-pixels SP1 to SP3. For example, the pixel defining layer PDL may be disposed in the non-emission area NEA (refer to FIG. 6) and define the first to third emission areas EMA1 to EMA3 (refer to FIG. 6).

The pixel defining layer PDL may include inorganic insulating layers. Each of the inorganic insulating layers may include at least one of silicon oxide (SiOₓ) and silicon nitride (SiNₓ). For example, the pixel defining layer PDL may include first to third inorganic insulating layers sequentially stacked, and the first to third inorganic insulating layers may include silicon nitride, silicon oxide (SiOₓ), and silicon nitride (SiNₓ), respectively. However, embodiments are not limited thereto.

The first to third light emitting structures EMS1 to EMS3 may be disposed on the first to third anodes AE1 to AE3, respectively. For example, the first to third light emitting structures EMS1 to EMS3 may be respectively disposed on the first to third anodes AE1 to AE3 exposed by the opening OP of the pixel defining layer PDL. The first to third light emitting structures EMS1 to EMS3 may overlap portions of the pixel defining layer PDL. For example, the first to third light emitting structures EMS1 to EMS3 may be disposed (e.g., directly disposed) on the portions of the pixel defining layer PDL.

The first light emitting structure EMS1 may include a hole injection layer HIL, a hole transport layer HTL, a first light emitting layer EML1, and a buffer layer BFL. The hole injection layer HIL of the first light emitting structure EMS1 may be disposed on the first anode AE1. The hole transport layer HTL of the first light emitting structure EMS1 may be disposed on the hole injection layer HIL of the first light emitting structure EMS1. In FIG. 7, the hole transport layer HTL of the first light emitting structure EMS1 is shown as being disposed on a portion of the pixel defining layer PDL, but embodiments are not limited thereto. The first light emitting layer EML1 may be disposed on the hole transport layer HTL of the first light emitting structure EMS1. In embodiments, the first light emitting layer EML1 may emit light of a red light. The buffer layer BFL of the first light emitting structure EMS1 may be disposed on the first light emitting layer EML1. The buffer layer BFL of the first light emitting structure EMS1 may protect the first light emitting layer EML1. For example, the buffer layer BFL of the first light emitting structure EMS1 may prevent an external substance such as oxygen and moisture from permeating into the first light emitting layer EML1. The buffer layer BFL may include an inorganic material such as silicon carbon nitride, but embodiments are not limited thereto.

The first light emitting structure EMS1 may further include an insulating layer formed on a surface. For example, the insulating layer may be disposed on a side of the hole injection layer HIL, the hole transport layer HTL, the first light emitting layer EML1, and/or the buffer layer BFL. The insulating layer may expose at least a portion of a lower surface of the hole injection layer HIL of the first light emitting structure EMS1. For example, the insulating layer may not be disposed on the lower surface of the hole injection layer HIL of the first light emitting structure EMS1, or may be partially disposed. Accordingly, the hole injection layer HIL of the first light emitting structure EMS1 and the first anode AE1 may be electrically connected to each other. For example, the insulating layer may expose at least a portion of an upper surface of the buffer layer BFL of the first light emitting structure EMS1. For example, the insulating layer may not be disposed on the upper surface of the buffer layer BFL of the first light emitting structure EMS1, or may be partially disposed. Accordingly, the buffer layer BFL of the first light emitting structure EMS1 and the electron transport layer ETL of the common layer CML may be electrically connected to each other.

The second light emitting structure EMS2 may include the hole injection layer HIL, the hole transport layer HTL, a second light emitting layer EML2, and the buffer layer BFL. The hole injection layer HIL of the second light emitting structure EMS2 may be disposed on the second anode AE2. The hole transport layer HTL of the second light emitting structure EMS2 may be disposed on the hole injection layer HIL of the second light emitting structure EMS2. In FIG. 7, the hole transport layer HTL of the second light emitting structure EMS2 is shown as being disposed on a portion of the pixel defining layer PDL, but embodiments are not limited thereto. The second light emitting layer EML2 may be disposed on the hole transport layer HTL of the second light emitting structure EMS2. In embodiments, the second light emitting layer EML2 may emit light of a green color. The buffer layer BFL of the second light emitting structure EMS2 may be disposed on the second light emitting layer EML2. The buffer layer BFL of the second light emitting structure EMS2 may protect the second light emitting layer EML2. For example, the buffer layer BFL of the second light emitting structure EMS2 may prevent an external substance such as oxygen and moisture from permeating into the second light emitting layer EML2.

The second light emitting structure EMS2 may further include an insulating layer formed on a surface. For example, the insulating layer may be disposed on a side of the hole injection layer HIL, the hole transport layer HTL, the second light emitting layer EML2, and/or the buffer layer BFL. The insulating layer may expose at least a portion of a lower surface of the hole injection layer HIL of the second light emitting structure EMS2. For example, the insulating layer may not be disposed on the lower surface of the hole injection layer HIL of the second light emitting structure EMS2, or may be partially disposed. Accordingly, the hole injection layer HIL of the second light emitting structure EMS2 and the second anode AE2 may be electrically connected to each other. For example, the insulating layer may expose at least a portion of an upper surface of the buffer layer BFL of the second light emitting structure EMS2. For example, the insulating layer may not be disposed on the upper surface of the buffer layer BFL of the second light emitting structure EMS2, or may be partially disposed. Accordingly, the buffer layer BFL of the second light emitting structure EMS2 and the electron transport layer ETL of the common layer CML may be electrically connected to each other.

The third light emitting structure EMS3 may include the hole injection layer HIL, the hole transport layer HTL, a third light emitting layer EML3, and the buffer layer BFL. The hole injection layer HIL of the third light emitting structure EMS3 may be disposed on the third anode AE3. The hole transport layer HTL of the third light emitting structure EMS3 may be disposed on the hole injection layer HIL of the third light emitting structure EMS3. In FIG. 7, the hole transport layer HTL of the third light emitting structure EMS3 is shown as being disposed on a portion of the pixel defining layer PDL, but embodiments are not limited thereto. The third light emitting layer EML3 may be disposed on the hole transport layer HTL of the third light emitting structure EMS3. In embodiments, the third light emitting layer EML3 may emit light of a blue color. The buffer layer BFL of the third light emitting structure EMS3 may be disposed on the third light emitting layer EML3. The buffer layer BFL of the third light emitting structure EMS3 may protect the third light emitting layer EML3. For example, the buffer layer BFL of the third light emitting structure EMS3 may prevent an external substance such as oxygen and moisture from permeating into the third light emitting layer EML3.

The third light emitting structure EMS3 may further include an insulating layer formed on a surface. For example, the insulating layer may be disposed on a side of the hole injection layer HIL, the hole transport layer HTL, the third light emitting layer EML3, and/or the buffer layer BFL. The insulating layer may expose at least a portion of a lower surface of the hole injection layer HIL of the third light emitting structure EMS3. For example, the insulating layer may not be disposed on the lower surface of the hole injection layer HIL of the third light emitting structure EMS3, or may be partially disposed. Accordingly, the hole injection layer HIL of the third light emitting structure EMS3 and the third anode AE3 may be electrically connected to each other. For example, the insulating layer may expose at least a portion of an upper surface of the buffer layer BFL of the third light emitting structure EMS3. For example, the insulating layer may not be disposed on the upper surface of the buffer layer BFL of the third light emitting structure EMS3, or may be partially disposed. Accordingly, the buffer layer BFL of the third light emitting structure EMS3 and the electron transport layer ETL of the common layer CML may be electrically connected to each other.

As described above, the buffer layer BFL may be individually disposed on the first to third light emitting layers EML1 to EML3 to protect the first to third light emitting layers EML1 to EML3.

The first to third light emitting layers EML1 to EML3 may include an organic light emitting material, but embodiments are not limited thereto. For example, the first to third light emitting layers EML1 to EML3 may include an inorganic light emitting material, a quantum dot, a quantum rod, or the like.

In embodiments, the first to third light emitting structures EMS1 to EMS3 may include a material that is resistant to moisture or etchant. For example, the first to third light emitting structures EMS1 to EMS3 may include a material that substantially maintains a characteristic such as a driving voltage, an emission efficiency, a color coordinate, and a lifespan of the display device DD (refer to FIG. 1) even after exposure to moisture or air. For example, the first to third light emitting structures EMS1 to EMS3 may include a material that substantially maintains an original form (or initial form) of the first to third light emitting structures EMS1 to EMS3 and the characteristic of the display device DD described above even after exposure to an etchant including phosphoric acid, nitric acid, and acetic acid.

The spacer SPC may be disposed on the pixel defining layer PDL. The spacer SPC may surround the first to third light emitting structures EMS1 to EMS3. The spacer SPC may remove a step between the pixel defining layer PDL and the first to third light emitting structures EMS1 to EMS3. For example, the spacer SPC may fill a gap between the pixel defining layer PDL and the first to third light emitting structures EMS1 to EMS3. The spacer SPC may include an organic material such as polyimide or an inorganic material such as silicon nitride (SiN_{X}), silicon oxide (SiO_{X}), or silicon oxynitride (SiO_{X}N_{Y}), but embodiments are not limited thereto. For example, the spacer SPC may include an organic material and an inorganic material.

The common layer CML may be continuously disposed across the first to third sub-pixels SP1 to SP3 (refer to FIG. 6). For example, the common layer CML may be disposed on the first to third light emitting structures EMS1 to EMS3 and the spacer SPC. In an embodiment, the common layer CML may include an electron transport layer ETL, an electron injection layer EIL, and the cathode CE. The electron transport layer ETL may be disposed on the first to third light emitting structures EMS1 to EMS3 and the spacer SPC. The electron injection layer EIL may be disposed on the electron transport layer ETL. The cathode CE may be disposed on the electron injection layer EIL. The common layer CML may include the electron transport layer ETL and the electron injection layer EIL that are divided into separate layers, but embodiments are not limited thereto. For example, the electron transport layer ETL and the electron injection layer EIL may be integrated into one layer (or single layer), and the single layer may include a composite material in which a material of the electron transport layer ETL and a material of the electron injection layer EIL are mixed.

An encapsulation layer TFE may be disposed on the display element layer DPL. For example, the encapsulation layer TFE may be disposed on the cathode CE. The encapsulation layer TFE may prevent an external substance such as oxygen and moisture from permeating into the display element layer DPL. The encapsulation layer TFE may include a structure (or member) in which one or more inorganic layers and one or more organic layers are alternately stacked. For example, the inorganic layer may include silicon nitride, silicon oxide (SiOₓ), or silicon oxynitride (SiOₓN_{y}). For example, the organic layer may include acrylic resin, epoxy resin, phenolic resin, polyamides resin, polyimides resin, unsaturated polyester resin, polyphenylenethers resin, polyphenylenesulfides resin, benzocyclobutene (BCB), or the like. However, embodiments are not limited thereto. For example, the encapsulation layer TFE may include aluminum oxide (AlOₓ).

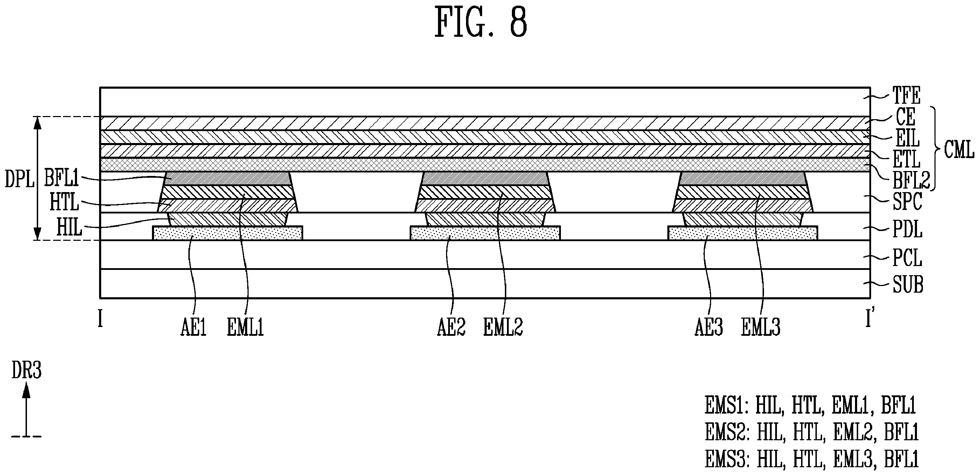

FIG. 8 is a schematic cross-sectional view taken along line I-I' of FIG. 6 according to an embodiment. Regarding FIG. 8, a description of a content overlapping FIG. 7 is simplified or omitted for descriptive convenience.

Referring to FIG. 8, each of the first to third light emitting structures EMS1 to EMS3 may include a first buffer layer BFL1. The first buffer layer BFL1 may be substantially the same as the buffer layer BFL shown in FIG. 7. For example, the first buffer layer BFL1 may be individually disposed on the first to third light emitting layers EML1 to EML3 to protect the first to third light emitting layers EML1 to EML3.

In an embodiment, the common layer CML may further include a second buffer layer BFL2. The second buffer layer BFL2 may be disposed on the first buffer layer BFL1 and the spacer SPC. The second buffer layer BFL2 may be disposed under the electron transport layer ETL. For example, the electron transport layer ETL may be disposed on the second buffer layer BFL2. The second buffer layer BFL2 may be continuously disposed on the first to third light emitting layers EML1 to EML3 to protect the first to third light emitting layers EML1 to EML3. The second buffer layer BFL2 may increase a buffer effect (or a protection effect). For example, the second buffer layer BFL2 may prevent an external substance such as oxygen and moisture from permeating into the first to third light emitting layers EML1 to EML3 from various directions. The second buffer layer BFL2 and the first buffer layer BFL1 may be formed of the same material. However, embodiments are not limited thereto.

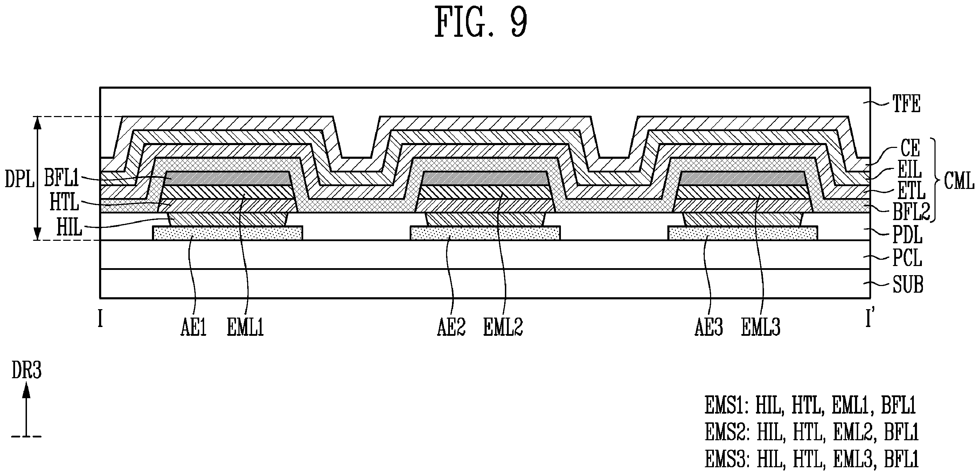

FIG. 9 is a schematic cross-sectional view taken along line I-I' of FIG. 6 according to an embodiment. Regarding FIG. 9, a description of a content overlapping FIGS. 7 and 8 is simplified or omitted for descriptive convenience.

Referring to FIG. 9, the display element layer DPL may not include a spacer SPC (refer to FIG. 7). For example, the common layer CML may be disposed on the first to third light emitting structures EMS1 to EMS3 and the pixel defining layer PDL. For example, the second buffer layer BFL2 may be disposed on the first to third light emitting structures EMS1 to EMS3 and the pixel defining layer PDL. The second buffer layer BFL2 may surround the first to third light emitting structures EMS1 to EMS3. The electron transport layer ETL may be disposed on the second buffer layer BFL2.

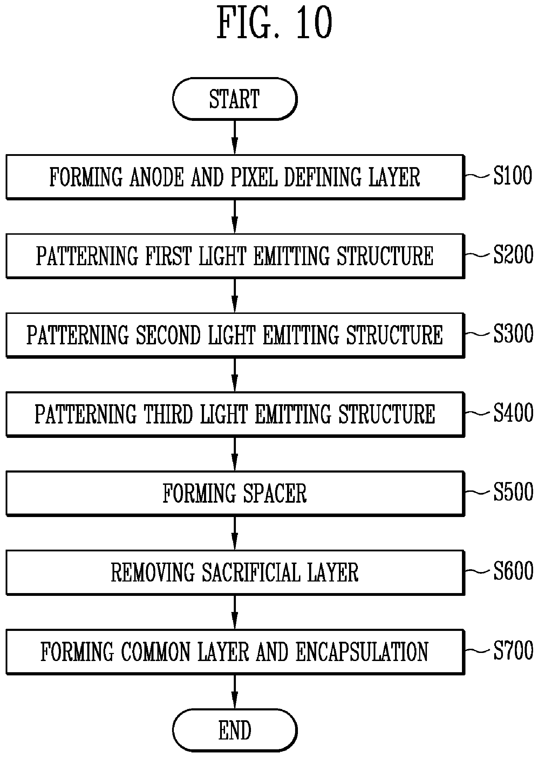

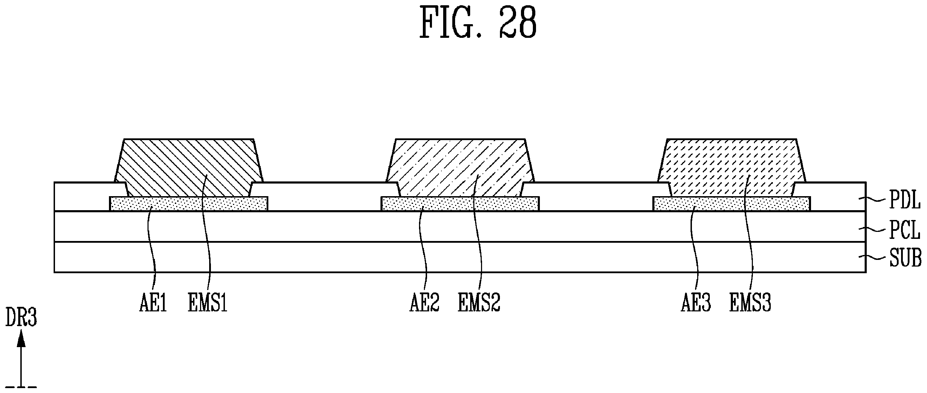

FIG. 10 is a schematic block diagram illustrating a method of manufacturing a display device according to an embodiment. FIGS. 11 to 29 are schematic cross-sectional views schematically illustrating a method of manufacturing a display device according to an embodiment. Hereinafter, a method of manufacturing a display device using a direct patterning process is described with reference to FIGS. 10 to 29.

Referring to FIGS. 10 and 11, a process S100 of forming the anode AE and the pixel defining layer PDL may be performed. For example, the first to third anodes AE1 to AE3 spaced apart from each other may be formed on the pixel circuit layer PCL on the substrate SUB. For example, the first anode AE1 may be patterned at a position corresponding to the first emission area EMA1 (refer to FIG. 6), the second anode AE2 may be patterned at a position corresponding to the second emission area EMA2 (refer to FIG. 6), and the third anode AE3 may be patterned at a position corresponding to the third emission area EMA3 (refer to FIG. 6). Thereafter, the pixel defining layer PDL may be formed on portions of the first to third anodes AE1 to AE3 and the pixel circuit layer PCL. For example, after forming the pixel defining layer PDL entirely on the first to third anodes AE1 to AE3 and the pixel circuit layer PCL, the pixel defining layer PDL may be etched to form the opening OP exposing the first to third anodes AE1 to AE3.

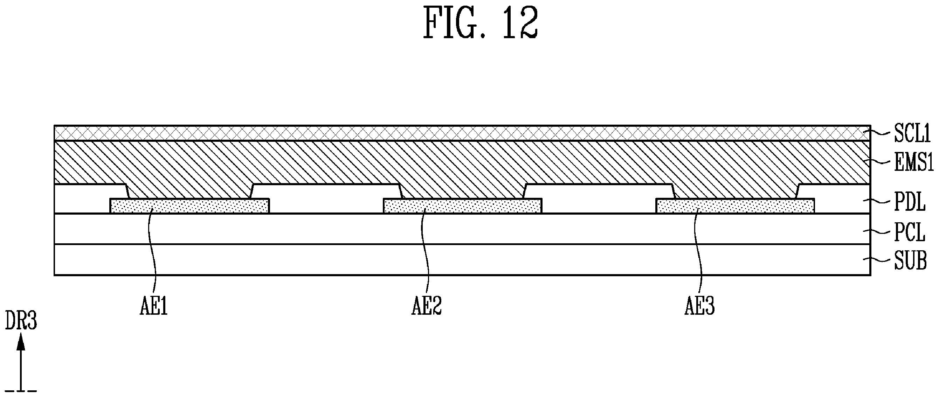

Referring to FIGS. 10 and 12 to 15, a patterning process S200 of forming the first light emitting structure EMS1(or first light emitting member) may be performed. Referring to FIG. 12, the first light emitting structure EMS1 may be formed on the first to third anodes AE1 to AE3 and the pixel defining layer PDL. A stack structure of the first light emitting structure EMS1 is as shown in FIG. 7. Thereafter, a first sacrificial layer SCL1 may be formed on the first light emitting structure EMS1. The first sacrificial layer SCL1 may be formed in a thickness suitable for protecting the first light emitting structure EMS1. The first sacrificial layer SCL1 may include aluminum (Al), but embodiments are not limited thereto.

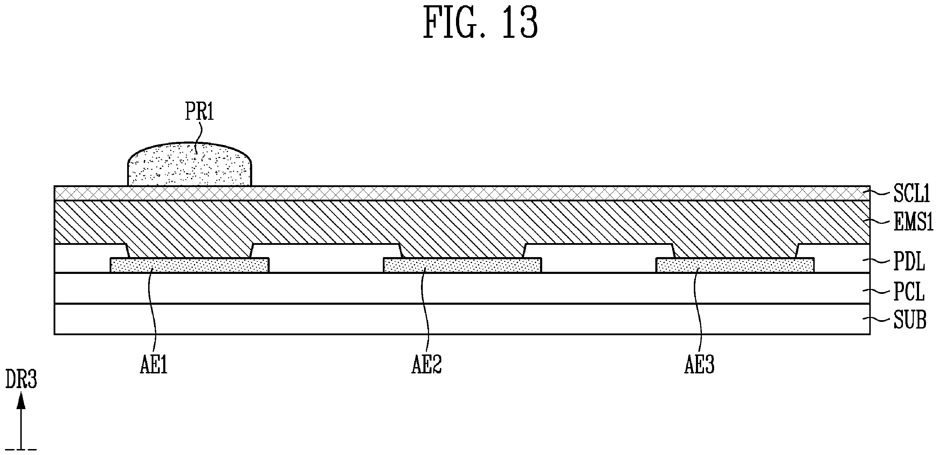

Referring to FIG. 13, thereafter, a first photo resist PR1 may be formed on a portion of the first sacrificial layer SCL1. For example, the first photo resist PR1 may be formed on a portion overlapping a portion of the first anode AE1 of the first sacrificial layer SCL1. The first photo resist PR1 may be formed through an exposure process and a development process.

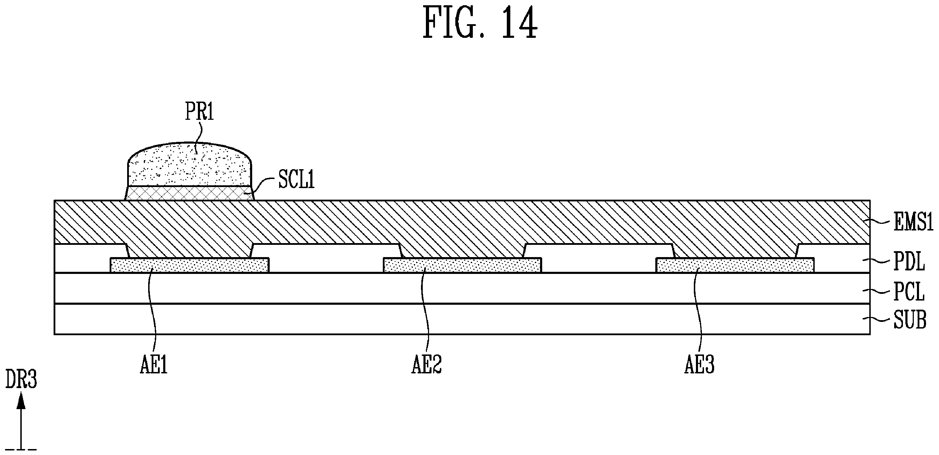

Referring to FIG. 14, thereafter, the first sacrificial layer SCL1 may be partially removed. For example, a portion that does not overlap the first photo resist PR1 of the first sacrificial layer SCL1 may be removed through an etching process. As shown in FIG. 14, a portion of the portion that does not overlap the first photo resist PR1 of the first sacrificial layer SCL1 may remain, but embodiments are not limited thereto. The etching process may be performed in a wet etching process or a dry etching process. Accordingly, the first light emitting structure EMS1 may be partially exposed.

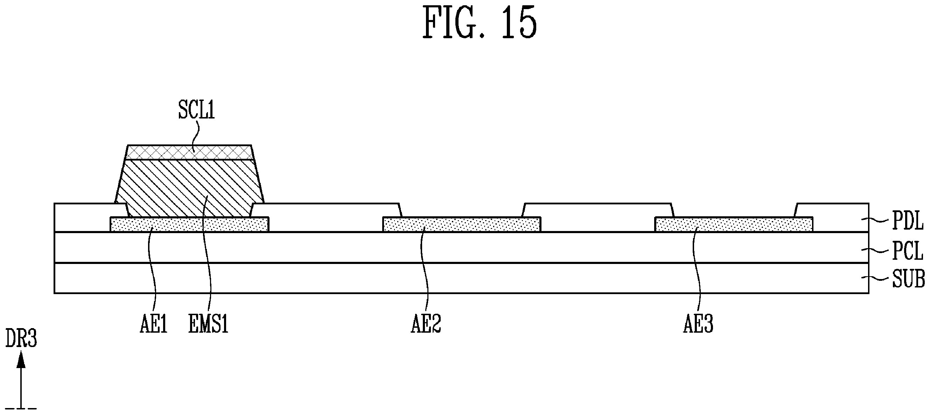

Referring to FIG. 15, thereafter, the first photo resist PR1 may be removed and the first light emitting structure EMS1 may be partially removed. For example, the first photo resist PR1 may be removed through an ashing process, and an exposed portion of the first light emitting structure EMS1 (or a portion that does not overlap the first sacrificial layer SCL1) may be removed through an etching process. As shown in FIG. 15, a portion of the exposed portion of the first light emitting structure EMS1 may remain, but embodiments are not limited thereto. Accordingly, the first light emitting structure EMS1 may be patterned at a position corresponding to the first anode AE1. The first sacrificial layer SCL1 may be positioned on the first light emitting structure EMS1.

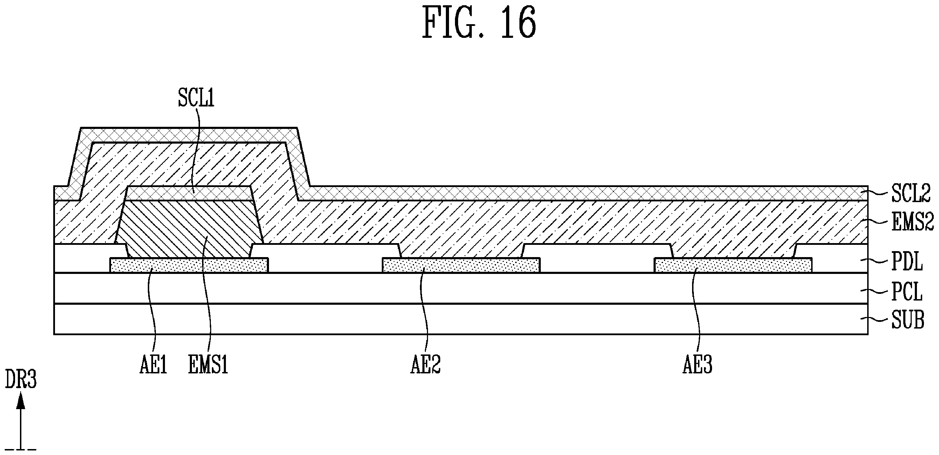

Referring to FIGS. 10 and 16 to 19, subsequently, a patterning process S300 of forming the second light emitting structure EMS2(or second light emitting member) may be performed. Referring to FIG. 16, the second light emitting structure EMS2 may be formed on the first sacrificial layer SCL1, the second and third anodes AE2 and AE3, and the pixel defining layer PDL. The second light emitting structure EMS2 may be formed to surround (or cover) the first light emitting structure EMS1 and the first sacrificial layer SCL1. A stack structure of the second light emitting structure EMS2 is as shown in FIG. 7. Thereafter, a second sacrificial layer SCL2 may be formed on the second light emitting structure EMS2. The second sacrificial layer SCL2 may be formed in a thickness suitable for protecting the second light emitting structure EMS2. The second sacrificial layer SCL2 and the first sacrificial layer SCL1 may be formed of the same material, but embodiments are not limited thereto. The second light emitting structure EMS2 and the second sacrificial layer SCL2 may have a step due to the first light emitting structure EMS1 and the first sacrificial layer SCL1.

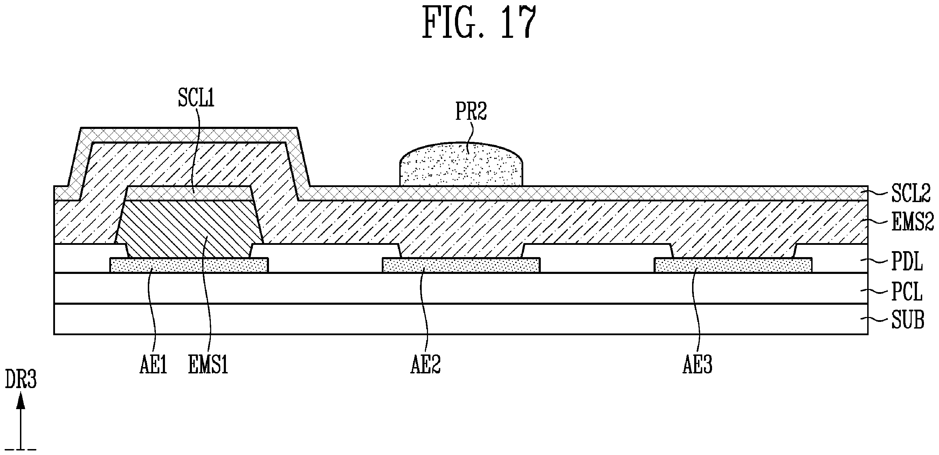

Referring to FIG. 17, thereafter, a second photo resist PR2 may be formed on a portion of the second sacrificial layer SCL2. For example, the second photo resist PR2 may be formed on a portion overlapping a portion of the second anode AE2 of the second sacrificial layer SCL2. The second photo resist PR2 may be formed through an exposure process and a development process. The second photo resist PR2 and the first photo resist PR1 may be formed of the same material, but embodiments are not limited thereto.

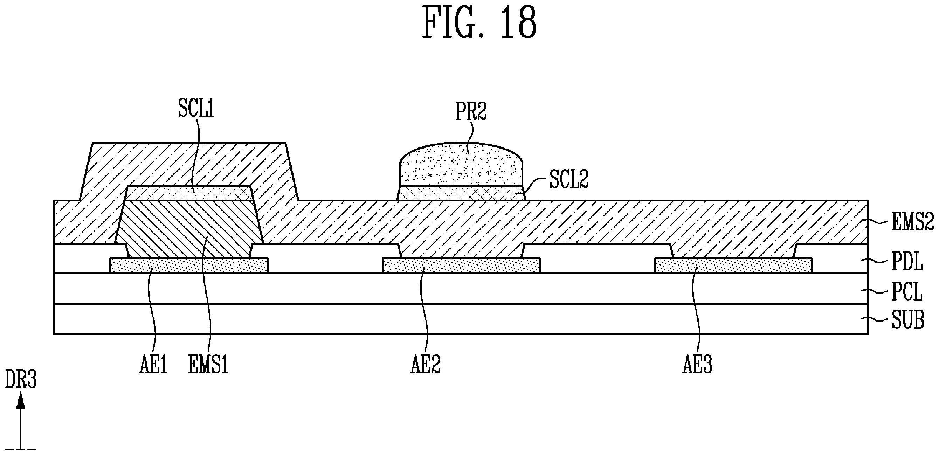

Referring to FIG. 18, the second sacrificial layer SCL2 may be partially removed. For example, a portion that does not overlap the second photo resist PR2 of the second sacrificial layer SCL2 may be removed through an etching process. As shown in FIG. 18, a portion of the portion that does not overlap the second photo resist PR2 of the second sacrificial layer SCL2 may remain, but embodiments are not limited thereto. The etching process may be performed in a wet etching process or a dry etching process. Accordingly, the second light emitting structure EMS2 may be partially exposed.

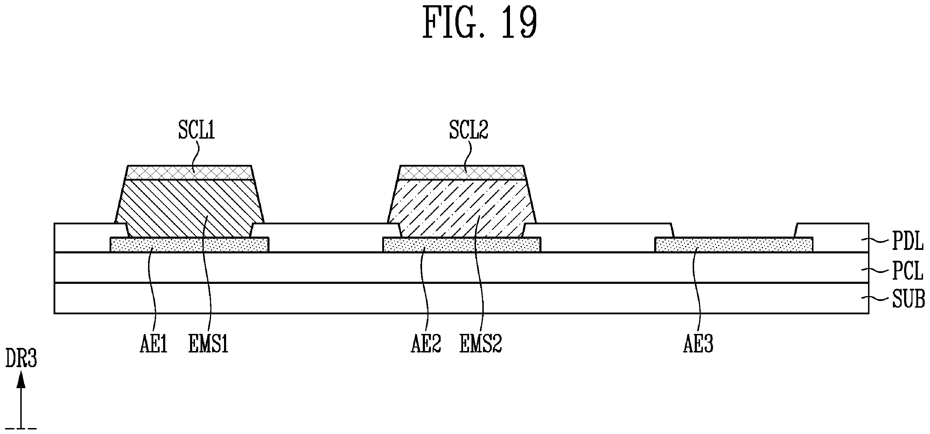

Referring to FIG. 19, thereafter, the second photo resist PR2 may be removed and the second light emitting structure EMS2 may be partially removed. For example, the second photo resist PR2 may be removed through an ashing process, and an exposed portion of the second light emitting structure EMS2 (or a portion that does not overlap the second sacrificial layer SCL2) may be removed through an etching process. As shown in FIG. 19, a portion of the exposed portion of the second light emitting structure EMS2 may remain, but embodiments are not limited thereto. Accordingly, the second light emitting structure EMS2 may be patterned at a position corresponding to the second anode AE2. The second sacrificial layer SCL2 may be positioned on the second light emitting structure EMS2.

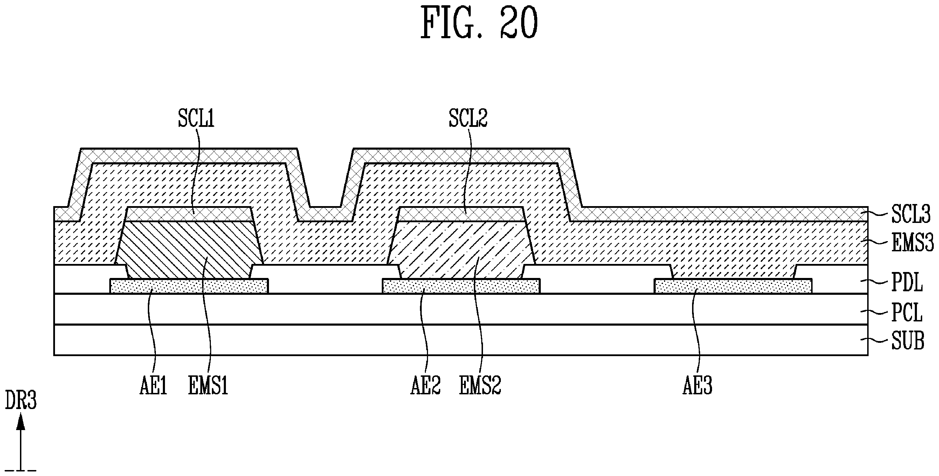

Referring to FIGS. 10 and 20 to 23, a patterning process S400 of forming the third light emitting structure EMS3 (or third light emitting member) may be performed. Referring to FIG. 20, the third light emitting structure EMS3 may be formed on the first sacrificial layer SCL1, the second sacrificial layer SCL2, the third anode AE3, and the pixel defining layer PDL. The third light emitting structure EMS3 may be formed to surround (or cover) the first and second light emitting structures EMS1 and EMS2 and the first and second sacrificial layers SCL1 and SCL2. A stack structure of the third light emitting structure EMS3 is as shown in FIG. 7. Thereafter, a third sacrificial layer SCL3 may be formed on the third light emitting structure EMS3. The third sacrificial layer SCL3 may be formed in a thickness suitable for protecting the third light emitting structure EMS3. The third sacrificial layer SCL3 and the first sacrificial layer SCL1 be formed of the same material, but embodiments are not limited thereto. The third light emitting structure EMS3 and the third sacrificial layer SCL3 may have a step due to the first and second light emitting structures EMS1 and EMS2 and the first and second sacrificial layers SCL1 and SCL2.

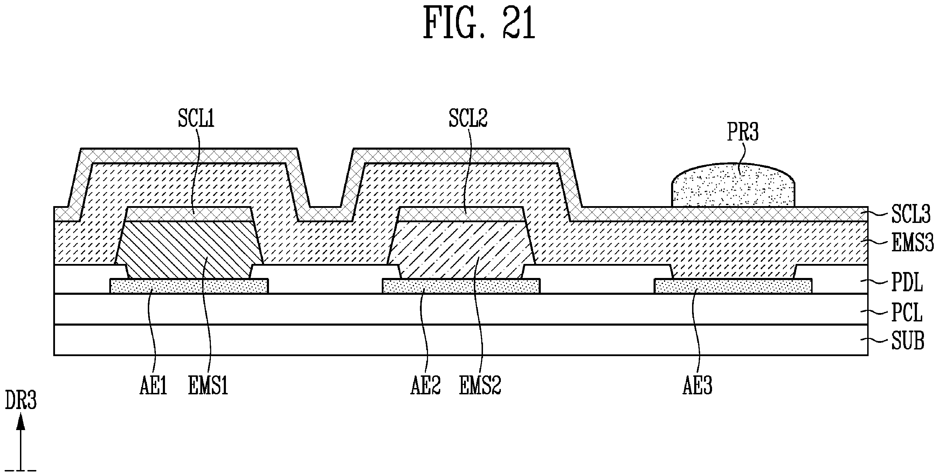

Referring to FIG. 21, thereafter, a third photo resist PR3 may be formed on a portion of the third sacrificial layer SCL3. For example, the third photo resist PR3 may be formed on a portion overlapping a portion of the third anode AE3 of the third sacrificial layer SCL3. The third photo resist PR3 may be formed through an exposure process and a development process. The third photo resist PR3 and the first photo resist PR1 may be formed of the same material, but embodiments are not limited thereto.

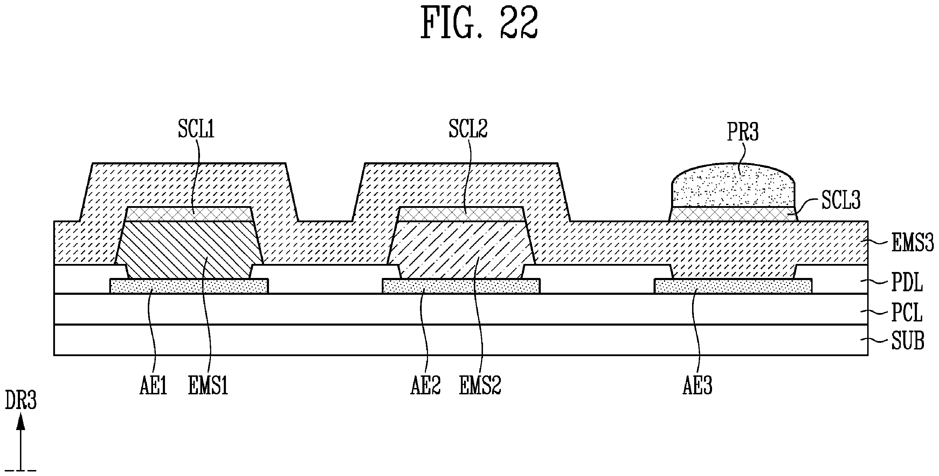

Referring to FIG. 22, thereafter, the third sacrificial layer SCL3 may be partially removed. For example, a portion that does not overlap the third photo resist PR3 of the third sacrificial layer SCL3 may be removed through an etching process. As shown in FIG. 22, a portion of the portion that does not overlap the third photo resist PR3 of the third sacrificial layer SCL3 may remain, but embodiments are not limited thereto. The etching process may be performed in a wet etching process or a dry etching process. Accordingly, the third light emitting structure EMS3 may be partially exposed.

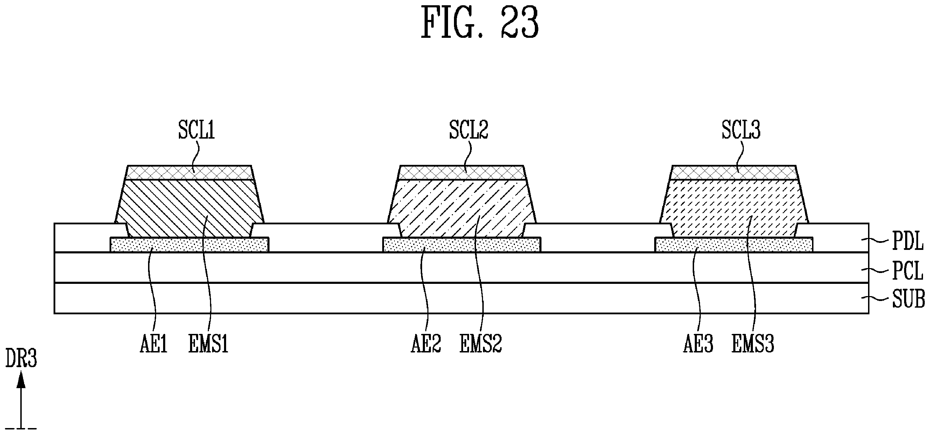

Referring to FIG. 23, thereafter, the third photo resist PR3 may be removed and the third light emitting structure EMS3 may be partially removed. For example, the third photo resist PR3 may be removed through an ashing process, and an exposed portion of the third light emitting structure EMS3 (or a portion that does not overlap the third sacrificial layer SCL3) may be removed through an etching process. As shown in FIG. 23, a portion of the exposed portion of the third light emitting structure EMS3 may remain, but embodiments are not limited thereto. Accordingly, the third light emitting structure EMS3 may be patterned at a position corresponding to the third anode AE3. The third sacrificial layer SCL3 may be positioned on the third light emitting structure EMS3.

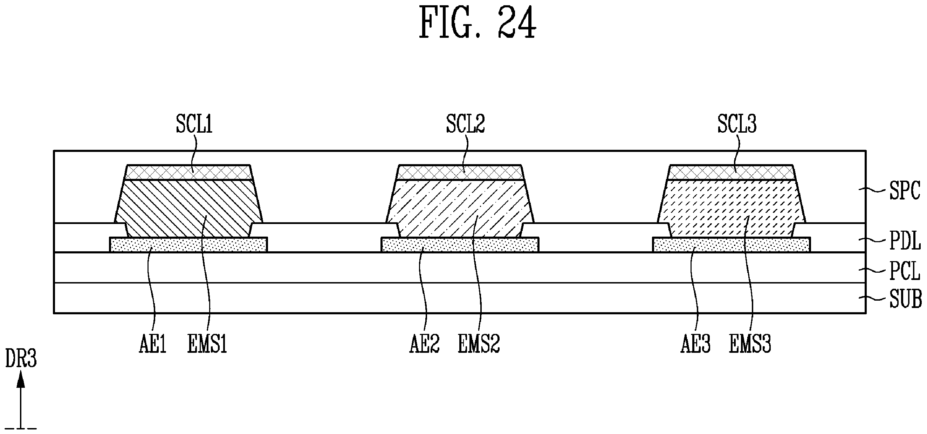

Referring to FIGS. 10, 24, and 25, subsequently, a process S500 of forming the spacer SPC may be performed. Referring to FIG. 24, the spacer SPC may be formed on the first to third sacrificial layers SCL1 to SLC3 and the pixel defining layer PDL. The spacer SPC may be formed to surround the first to third light emitting structures EMS1 to EMS3 and the first to third sacrificial layers SCL1 to SCL3.

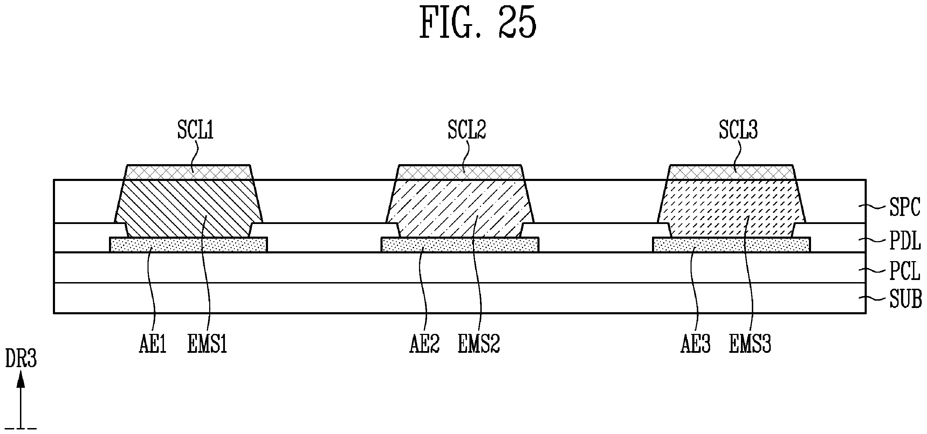

Referring to FIG. 25, thereafter, the spacer SPC may be partially removed. The spacer SPC may be removed through an etching process so that the first to third sacrificial layers SCL1 to SLC3 may be exposed. The etching process may be performed in a dry etching process.

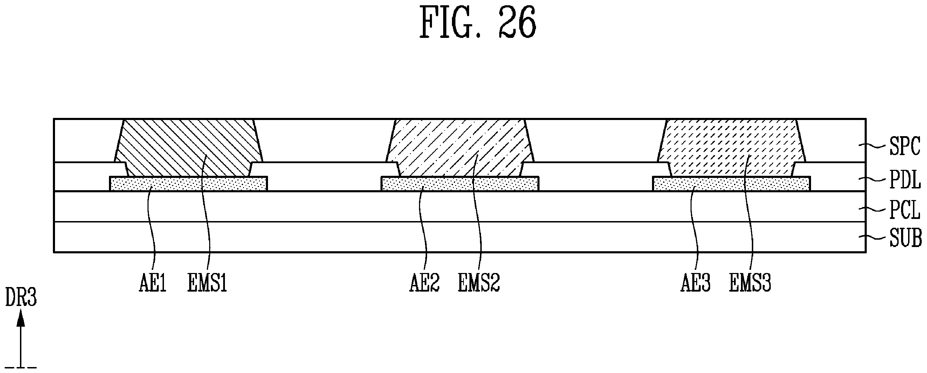

Referring to FIGS. 10 and 26, subsequently, a process S600 of removing a sacrificial layer may be performed. The first to third sacrificial layers SCL1 to SCL3 (refer to FIG. 25) may be removed through an etching process. The etching process may be performed in a wet etching process. Accordingly, an upper surfaces of the first to third light emitting structures EMS1 to EMS3 may be exposed. After the process S600 of removing the sacrificial layer, a drying process for removing moisture may be performed. For example, the drying process may be performed at a temperature of about 90°C and in a vacuum state.

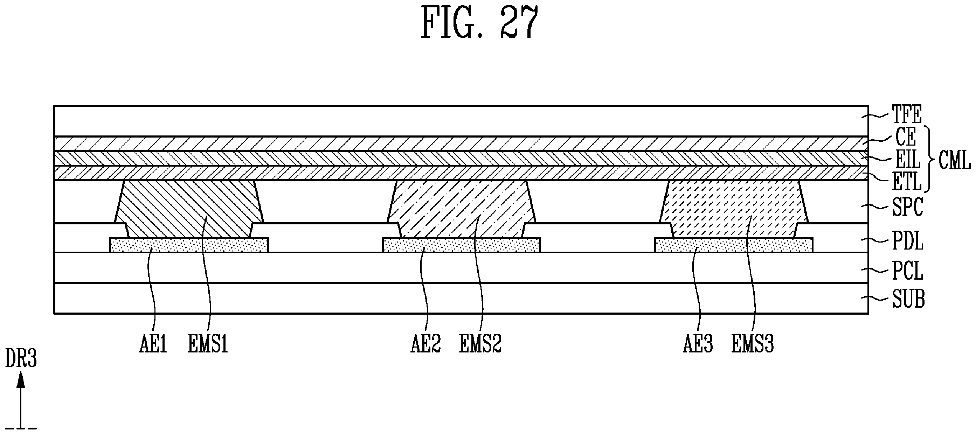

Referring to FIGS. 10 and 27, subsequently, a process S700 of forming the common layer CML and the encapsulation layer TFE may be performed. For example, the common layer CML may be formed. For example, the electron transport layer ETL may be formed on the first to third light emitting structures EMS1 to EMS3 and the spacer SPC. Thereafter, the electron injection layer EIL may be formed on the electron transport layer ETL. Thereafter, the cathode CE may be formed on the electron injection layer EIL. Differently from that shown in FIG. 27, the second buffer layer BFL2 (refer to FIG. 8) may be formed on the first to third light emitting structures EMS1 to EMS3 and the spacer SPC. For example, the electron transport layer ETL, the electron injection layer EIL, and the cathode CE may be sequentially formed on the second buffer layer BFL2. Thereafter, the encapsulation layer TFE may be formed on the common layer CML.

Referring to FIGS. 10, 25, and 28, after the patterning process S400 of forming the third light emitting structure EMS3, a process S600 of removing a sacrificial layer may be performed. For example, the process S500 of forming the spacer SPC may be omitted. The process S600 of removing the sacrificial layer may be performed identically to that described above. After the process S600 of removing the sacrificial layer, the drying process described above may be performed identically.

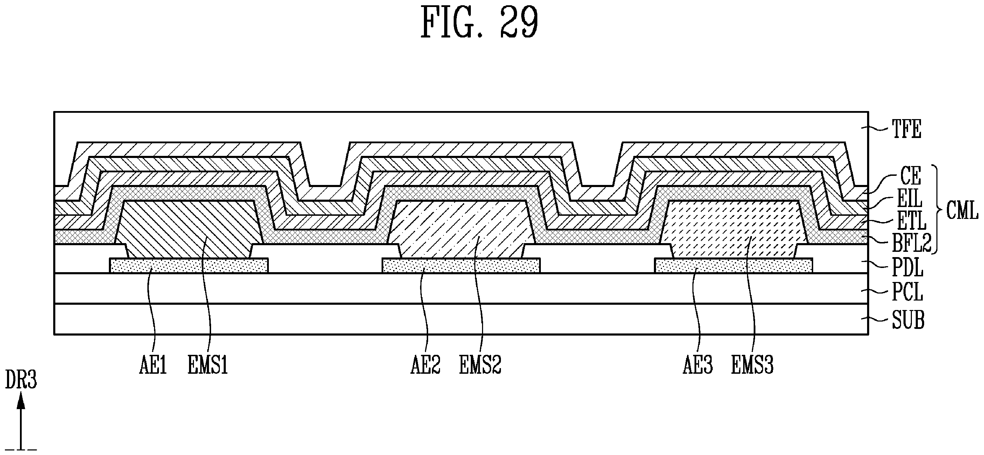

Referring to FIGS. 10 and 29, subsequently, a process S700 of forming the common layer CML and the encapsulation layer TFE may be performed. For example, the common layer CML may be formed. For example, the second buffer layer BFL2 may be formed on the first to third light emitting structures EMS1 to EMS3 and the pixel defining layer PDL. The second buffer layer BFL2 may be continuously formed over the first to third light emitting structures EMS1 to EMS3 and the pixel defining layer PDL. Thereafter, the electron transport layer ETL may be formed on the second buffer layer BFL2. Thereafter, the electron injection layer EIL may be formed on the electron transport layer ETL. Thereafter, the cathode CE may be formed on the electron injection layer EIL. Thereafter, the encapsulation layer TFE may be formed on the common layer CML. Differently from that shown in FIG. 29, the encapsulation layer TFE may have a step due to the common layer CML.

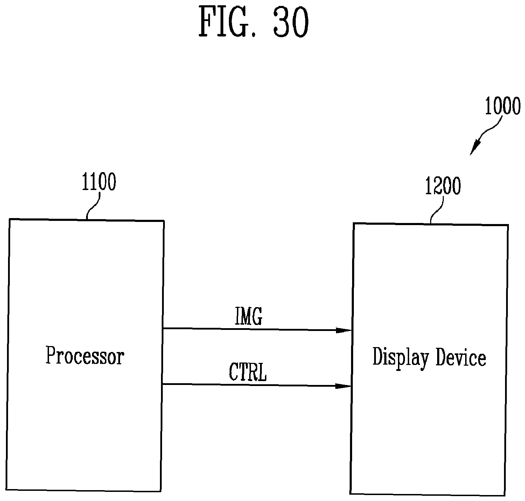

FIG. 30 is a schematic block diagram illustrating a display system according to an embodiment.

Referring to FIG. 30, the display system 1000 may include a processor 1100 and a display device 1200.

The processor 1100 may perform various tasks and calculations. In embodiments, the processor 1100 may include an application processor, a graphics processor, a microprocessor, a central processing unit (CPU), and the like. The processor 1100 may be connected to other components of the display system 1000 through a bus system to control the other components.

The processor 1100 may transmit image data IMG and a control signal CTRL to the display device 1200. The display device 1200 may display an image based on the image data IMG and the control signal CTRL. The display device 1200 may be implemented similarly to the display device DD described with reference to FIG. 1. For example, the image data IMG and the control signal CTRL may be provided as the input image data IMG and the control signal CTRL of FIG. 1, respectively.

The display system 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, an ultra mobile personal computer (UMPC), a TV, and a monitor. For example, the display system 1000 may include at least one of a head mounted display (HMD) device, a virtual reality (VR) device, a mixed reality (MR) device, and an augmented reality (AR) device.

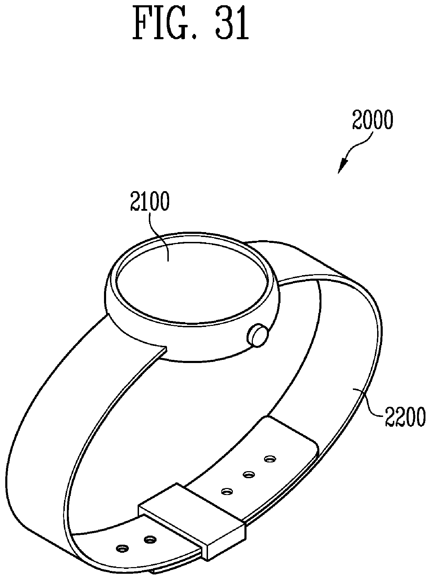

FIGS. 31 to 34 are schematic perspective views illustrating application examples of the display system of FIG. 30.

Referring to FIG. 31, the display system 1000 of FIG. 30 may be applied to a smart watch 2000 including a display unit 2100 and a strap unit 2200.

The smart watch 2000 may be a wearable electronic device. For example, the smart watch 2000 may have a structure in which the strap unit 2200 is mounted on a user's wrist. For example, the display system 1000 and/or the display device 1200 may be applied to the display unit 2100, and image data including time information may be provided to a user.

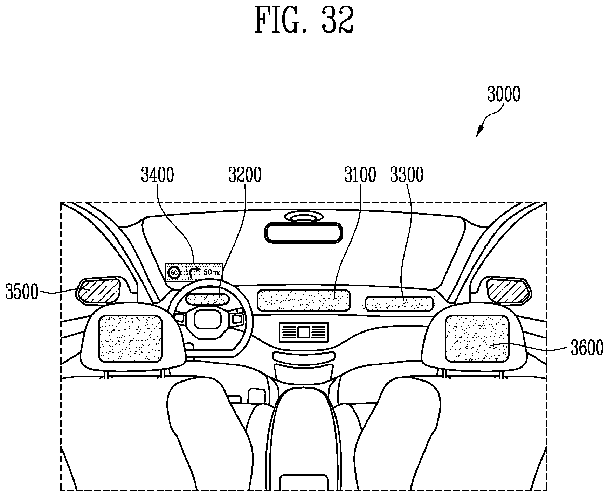

Referring to FIG. 32, the display system 1000 of FIG. 30 may be applied to an automotive display system 3000. For example, the automotive display system 3000 may include a computing system provided inside and/or outside a vehicle to provide image data.

For example, the display system 1000 and/or the display device 1200 may be applied to at least one of an infotainment panel 3100, a cluster 3200, a co-driver display 3300, a head-up display 3400, a side mirror display 3500, and a rear seat displays 3600 provided in a vehicle.

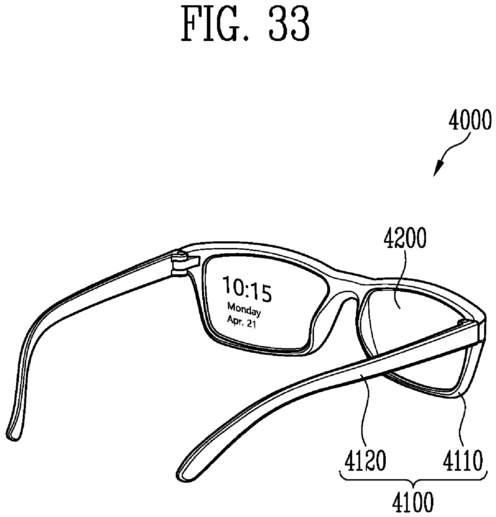

Referring to FIG. 33, the display system 1000 of FIG. 30 may be applied to smart glasses 4000. The smart glasses 4000 may be a wearable electronic device that is worn on a user's head. For example, the smart glasses 4000 may be a wearable device for augmented reality.

The smart glasses 4000 may include a frame 4100 and a lens unit 4200. The frame 4100 may include a housing 4110 that supports the lens unit 4200 and a leg unit 4120 for the user to wear. The leg unit 4120 may be connected to the housing 4110 through a hinge and may be folded or unfolded relative to the housing 4110.

A battery, a touch pad, a microphone, a camera, and the like may be built in the frame 4100. For example, a projector that outputs light, a processor that controls a light signal, and the like may be built in the frame 4100.

The lens unit 4200 may include an optical member that transmits or reflects light. For example, the lens unit 4200 may include glass, transparent synthetic resin, or the like.

In order for user's eyes to recognize visual information, the lens unit 4200 may reflect an image by the light signal transmitted from the projector of the frame 4100 by a rear surface (for example, a surface of a direction facing the user's eyes) of the lens unit 4200. For example, the user may recognize visual information such as time and date displayed on the lens unit 4200. For example, the projector and/or the lens unit 4200 may be a type of display device. The display device 1200 may be applied to the projector and/or the lens unit 4200.

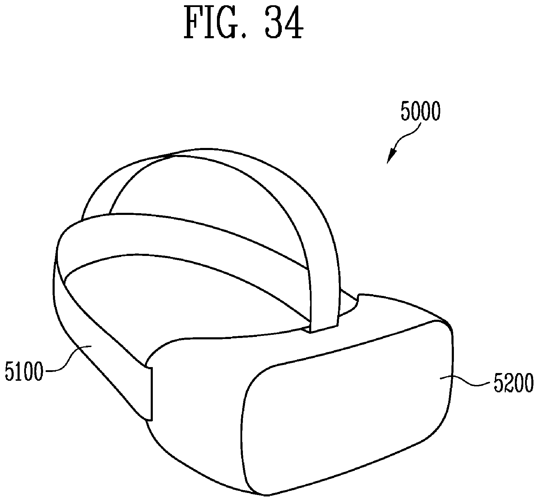

Referring to FIG. 34, the display system 1000 of FIG. 30 may be applied to a head mounted display device 5000.

The head mounted display device 5000 may be a wearable electronic device that is worn on a user's head. For example, the head mounted display device 5000 may be a wearable device for virtual reality or mixed reality.

The head mounted display device 5000 may include a head mount band 5100 and a display device receiving case 5200. The head mount band 5100 may be connected to the display device receiving case 5200. The head mount band 5100 may include a horizontal band and/or a vertical band for fixing the head mounted display device 5000 to a user's head. The horizontal band may surround a side portion of the user's head, and the vertical band may surround an upper portion of the user's head. However, embodiments are not limited thereto. For example, the head mount band 5100 may be implemented in a form of a glasses frame, a helmet, or the like.

The display device receiving case 5200 may receive the display system 1000 and/or the display device 1200.

In concluding the detailed description, those skilled in the art will appreciate that many variations and modifications may be made to the embodiments without substantially departing from the principles and spirit and scope of the disclosure. Therefore, the disclosed embodiments are used in a generic and descriptive sense only and not for purposes of limitation.

## Claims

1. A display device (1200, DD) comprising:
a substrate (SUB);
a pixel circuit layer (PCL) disposed on the substrate (SUB);
first, second, and third anodes (AE1, AE2, AE3) disposed on the pixel circuit layer (PCL) and spaced apart from each other;
a pixel defining layer (PDL) disposed on the pixel circuit layer (PCL) and overlapping portions of the first, second, and third anodes (AE1, AE2, AE3);
first, second, and third light emitting members respectively disposed on the first, second, and third anodes (AE1, AE2, AE3); and
a common layer (CML) disposed on the first, second, and third light emitting members.

2. The display device (1200, DD) of claim 1, wherein each of the first, second, and third light emitting members comprises:
a hole injection layer (HIL);
a hole transport layer (HTL) disposed on the hole injection layer (HIL);
a light emitting layer (EML1, EML2, EML3) disposed on the hole transport layer (HTL); and
a first buffer layer (BFL1) disposed on the light emitting layer (EML1, EML2, EML3).

3. The display device (1200, DD) of claim 2, wherein the common layer (CML) comprises:
an electron transport layer (ETL);
an electron injection layer (EIL) disposed on the electron transport layer (ETL); and
a cathode (CE) disposed on the electron injection layer (EIL).

4. The display device (1200, DD) of claim 3, further comprising:
a spacer (SPC) disposed between the pixel defining layer (PDL) and the electron transport layer (ETL) and surrounding the first, second, and third light emitting members and/or wherein the common layer (CML) further includes a second buffer layer (BFL2) disposed on the spacer (SPC) and the first, second, and third light emitting members and disposed under the electron transport layer (ETL).

5. The display device (1200, DD) of claim 3 or 4, wherein the common layer (CML) further includes a second buffer layer (BFL2) disposed on the pixel defining layer (PDL) and the first, second, and third light emitting members and disposed under the electron transport layer (ETL).

6. A method of manufacturing a display device (1200, DD), the method comprising:
forming a first anode (AE1), a second anode (AE2), a third anode (AE3), and a pixel defining layer (PDL) on a pixel circuit layer (PCL) on a substrate (SUB);
forming a first light emitting member on the first anode (AE1), the second anode (AE2), the third anode (AE3), and the pixel defining layer (PDL), and forming a first sacrificial layer (SCL1) on the first light emitting member;
forming a first photo resist (PR1) on a portion overlapping a portion of the first anode (AE1) of the first sacrificial layer;
removing a portion that does not overlap the first photo resist (PR1) of the first sacrificial layer; (SCL1) and
removing a portion that does not overlap the first sacrificial layer (SCL1) of the first light emitting member and the first photo resist (PR1).

7. The method of claim 6, further comprising:
forming a second light emitting member on the first sacrificial layer (SCL1), the second anode (AE2), the third anode (AE3), and the pixel defining layer (PDL), and forming a second sacrificial layer (SCL2) on the second light emitting member;
forming a second photo resist (PR2) on a portion that overlaps a portion of the second anode (AE2) of the second sacrificial layer (SCL2);
removing a portion that does not overlap the second photo resist (PR2) of the second sacrificial layer (SCL2); and
removing a portion that does not overlap the second sacrificial layer (SCL2) of the second light emitting member and the second photo resist (PR2).

8. The method of claim 7, further comprising:
forming a third light emitting member on the first sacrificial layer (SCL1), the second sacrificial layer (SCL2), the third anode (AE3), and the pixel defining layer (PDL), and forming a third sacrificial layer (SCL3) on the third light emitting member;
forming a third photo resist (PR3) on a portion overlapping a portion of the third anode (AE3) of the third sacrificial layer (SCL3);
removing a portion that does not overlap the third photo resist (PR3) of the third sacrificial layer (SCL3); and
removing a portion that does not overlap the third sacrificial layer (SCL3) of the third light emitting member and the third photo resist (PR3).

9. The method of claim 8, wherein each of the first, second, and third light emitting members comprises:
a hole injection layer (HIL);
a hole transport layer (HTL) disposed on the hole injection layer (HIL);
a light emitting layer disposed on the hole transport layer (HTL); and
a first buffer layer (BFL1) disposed on the light emitting layer.

10. The method of claim 9, further comprising:
forming a spacer (SPC) on the pixel defining layer (PDL) to cover the first, second, and third light emitting members and the first, second, and third sacrificial layers (SCL1, SCL2, SCL3).

11. The method of claim 10, further comprising:
removing a portion of the spacer (SPC) to expose the first, second, and third sacrificial layers (SCL1, SCL2, SCL3).

12. The method of claim 11, further comprising:
removing the first, second, and third sacrificial layers (SCL1, SCL2, SCL3) and/or
forming a common layer (CML) on the first, second, and third light emitting members and the spacer (SPC).

13. The method of claim 12, wherein forming the common layer (CML) comprises:
forming an electron transport layer (ETL) on the first, second, and third light emitting members and the spacer (SPC);
forming an electron injection layer (EIL) on the electron transport layer (ETL); and
forming a cathode (CE) on the electron injection layer (EIL).

14. The method of claim 12, wherein forming the common layer (CML) comprises:
forming a second buffer layer (BFL2) on the first, second, and third light emitting members and the spacer (SPC);
forming an electron transport layer (ETL) on the second buffer layer (BFL2);
forming an electron injection layer (EIL) on the electron transport layer (ETL); and
forming a cathode (CE) on the electron injection layer (EIL).

15. The method of claims 9 to 14, further comprising:
removing the first, second, and third sacrificial layers (SCL1, SCL2, SCL3) and/or forming a common layer (CML) on the first, second, and third light emitting members and the pixel defining layer (PDL).
